# EUROPEAN PATENT APPLICATION

(11) **EP 2 348 271 A1**
(43) Date of publication of application: **27.07.2011**
(21) Application number: 09825875.9
(22) Date of filing: 30.10.2009
(51) Int. Cl.: F28D 15/02

(54) **EBULLIENT COOLING APPARATUS**

(30) Priority: 17.11.2008 JP 2008293254
(71) Applicant: Kabushiki Kaisha Toyota Jidoshokki, Kariya-shi, Aichi 448-8671 (JP)
(72) Inventor: YOSHIHARA, Koji, Kariya-shi Aichi 448-8671 (JP); HARIU, Satoshi, Kariya-shi Aichi 448-8671 (JP)
(74) Representative: TBK
(86) International application number: PCT/JP2009/005796
(87) International publication number: WO 2010/055621

(57) **Abstract**

**[Assignment]** To provide an ebullient cooling device that can prevent the freezing of liquid cooling medium, and which can inhibit the occurrence of burnout.

**[Means for Solution]** An ebullient cooling device 1 according to the present invention is **characterized in that** it includes an accommodating unit 2 in which a liquid cooling medium is accommodated, the liquid cooling medium receiving heat that results from a heating element "Z," and is an ebullient cooling device to be installed in vehicle, wherein the liquid cooling medium is a mixed liquid of water and ethanol, and the mixed liquid has an ethanol concentration of 40% by mass or more.

## Description

### TECHNICAL FIELD

The present invention is one which relates to an ebullient cooling device that uses a cooling medium.

### BACKGROUND ART

An ebullient cooling device is a device for cooling a heating element utilizing the phase change of a cooling medium from liquid to gas. Here, in sealed-system ebullient cooling devices, it is often the case that the liquid cooling media, which receive heat from the heating elements, are alcohols. For example, in Japanese Unexamined Patent Publication (KOKAI) Gazette No. 4-257,693 (or Patent Literature No.1), there is set forth a mixed liquid of water (100) and a lower alcohol (from 5 to 12). The cooling medium herein is intended for heat pipe that is used to cool indoor instruments mainly, and is made so as not to be freezable at -10°C approximately, and to be nonflammable.

Moreover, in Japanese Unexamined Utility Model Publication (KOKAI) Gazette No. 62-8,571 (or Patent Literature No. 2), there is set forth a mixed liquid of water and an alcohol. The freezing of the cooling medium is prevented herein by changing the blending ratio of the water with the alcohol.

Meanwhile, the following studies have also been carried out in ebullient cooling devices: what the heat-transfer characteristics, and the like, have become of depending on the spatial constructions between the parts for accommodating the liquid cooling media like those mentioned above and the parts for conveying the heating elements' heat to the liquid cooling media. For example, in "Nucleate-boiling Heat Transfer at Narrow Gap" (or Non-patent Literature No. 1) according to A112 in the collection of lecture papers in the Twenty-second Japan Heat-transfer Symposium (May, 1985) , there are set forth relationships between heat-transfer characteristics and separation distances between the heat-transferring faces and the other faces facing thereto.
Patent Literature No. 1: Japanese Unexamined Patent Publication (KOKAI) Gazette No. 4-257,693;
Patent Literature No. 2: Japanese Unexamined Utility Model Publication (KOKAI) Gazette No. 62-8,571; and
Non-patent Literature No. 1: "Nucleate-boiling Heat Transfer at Narrow Gap" according to A112 in the collection of lecture papers in the Twenty-second Japan Heat-transfer Symposium (May, 1985)

### DISCLOSURE OF THE INVENTION

### Assignment to be Solved by the Invention

However, in a case where an alcohol is used as a cooling medium, the resulting limit heat flux is smaller compared with that of water, and so there is such a possibility that burnout (or film boiling) might occur with respect to heating elements that give rise to high heat fluxes. Adjacent to a heat-transferring face that conveys a heating element's heat to a liquid cooling medium, the burnout phenomenon occurs when a heat flux that has received the heat surpassed a limit heat flux that the liquid cooling medium possesses. Meanwhile, in a case where water is used as a cooling medium, the resultant cooling medium has frozen readily because it has the higher melting point (or solidification point) compared with that of alcohol. If so, it is not possible to clear the general required specification for ebullient cooling device to be installed in vehicle. Moreover, even when being a mixed liquid of water and an alcohol like those mentioned above, it is not possible to clear the aforementioned required specification, depending on the type and blending proportion of the alcohol; and there is such a possibility that the resulting heat-transfer efficiency might become smaller. The more electronic instruments, and the like, are downsized, or the more they are highly integrated, the higher the resultant heat fluxes (or heat-generation densities) become (1MW/m², for instance) , and hence burnout becomes likely to occur in mixed liquids whose limit heat fluxes are small. In a region where burnout has occurred, the cooling performance has declined because no heat transfer is carried out.

Against such a problem that the decline of latent heat has heretofore become larger conventionally, compared with that of water, in compositional liquids in which alcohols are mixed in an amount of 20% by volume or more, Patent Literature No. 1 describes a method for securing an amount of heat transport by decreasing the proportion of alcohol so that the proportion of an alcohol can be from 5 to 12%-by-volume alcohol with respect to 100%-by-volume water. Hence, it does not at all suggest the types and mixing proportions of alcohols in such a case where alcohols are mixed greatly (e.g., in an amount of 20% by volume or more).

Moreover, although Patent Literature No. 2 sets forth in Table 1 that it is possible to make the solidification point -29 °C by using a mixed liquid in which 40% alcohol is mixed with respect to 60% water, it is necessary to further increase the mixing proportion of alcohol in order to make the mixed liquid non-freezable securely even at -30 °C. However, although burnout becomes likely to occur because the amount of heat transfer has declined when increasing the mixing proportion of alcohol, it does not at all suggest any countermeasure against that issue.

The present invention is one which has been done in view of such circumstances, and it is an object to provide an ebullient cooling device that can prevent the freezing of liquid cooling medium, and which can inhibit the occurrence of burnout.

### Means for Solving the Assignment

An ebullient cooling device according to the present invention is characterized in that:
it is an ebullient cooling device comprising:
   an accommodating unit in which a liquid cooling medium is accommodated, the liquid coolingmediumreceiving heat that results from a heating element;
it is an ebullient cooling device to be installed in vehicle;
the liquid cooling medium is a mixed liquid of water and ethanol; and
the mixed liquid has an ethanol concentration of 40% by mass or more.

In the present invention, a mixed liquid of water and ethanol is used for the liquid cooling medium. Since ethanol has a lower melting point compared with those of the other alcohols, it is likely to lower the melting points in mixed liquids with water. That is, it is allowable that an amount of ethanol, which is needed for the mixed liquid in order to reach a targeted melting-point temperature, can be less than those when the other alcohols are mixed. In accordance with this setting, compared with the other alcohols, it is possible to make the proportion of water in the mixed liquid larger, and so it is possible to make the mixed liquid greater in the limit heat flux. Note herein that it is even permissible that the ebullient cooling device according to the present invention can further comprise a condensing unit that lies successively to the accommodating unit, and which condenses the liquid cooling medium that has been boiled by means of the heat of the heating element; and can be a sealed system.

And, in accordance with the present invention, it is possible to clear the specification that is generally required for the installation in vehicle (being non-freezable at -30 °C, for instance) , because setting the ethanol concentration to 40% by mass or more makes the resulting melting point less than -30 °C. Furthermore, to such an extent that water is included in the mixed liquid, the liquid cooling medium becomes greater in the limit heat flux than does the alcoholic single component. In accordance with this setting, the occurrence of burnout is inhibited.

Moreover, ethanol has a larger heat of evaporation (or latent heat) compared with those of the other alcohols. Therefore, using ethanol makes the resulting limit heat fluxmuch greater. In addition, ethanol is effective as a cooling medium for ebullient cooling, because it has such a low melting point relatively that makes the efficiency of thermal circulation better. Moreover, since ethanol has a boiling point that is not too low, namely, since the boiling point of ethanol is higher than a temperature (65 °C, for instance) in a cooling medium (or coolant water, for instance) that has been used for condensing at condensing units in general, ethanol is more suitable for ebullient cooling.

Thus, since the aforementioned liquid cooling medium comprising water and ethanol is used in the ebullient cooling device according to the present invention, the liquid cooling medium is prevented from freezing, and burnout is inhibited from occurring.

Here, in the present invention, it is preferable that the mixed liquid can have an ethanol concentration of from 45% by mass or more to 75% by mass or less. In accordance with this setting, the freezing can be prevented more securely, and burnout can be inhibited more. In addition, it is preferable that the mixed liquid can have an ethanol concentration of from 45% by mass or more to 55% by mass or less.

Note that it is preferable that the accommodating unit can have a heat-transferring wall portion that conveys the heat of the heating element to the liquid cooling medium, and a facing wall portion that faces the heat-transferring wall portion by way of the liquid cooling medium; and a separation distance between the heat-transferring wall portion and the facing wall portion can be 3 mm or less. In accordance with this setting, the resulting heat transfer coefficient upgrades, and hence the resultant cooling performance upgrades. Moreover, it is preferable that the separation distance between the heat-transferring wall portion and the facing wall portion can be 2 mm or less. In addition, it is further preferable that the separation distance between the heat-transferring wall portion and the facing wall portion can be from 0.5 mm or more to 1.5 mm or less.

### Effect of the Invention

In accordance with the ebullient cooling device according to the present invention, it is possible to prevent the liquid cooling medium from freezing, and the occurrence of burnout can be inhibited.

### BRIEF DESCRIPTION OF THE DRAWINGS

Fig. 1 is a schematic perspective diagram that illustrates an ebullient cooling device 1;
Fig. 2 is a cross-sectional diagram being viewed in the direction of "A"-"A" in Fig. 1;
Fig. 3 is a diagram that shows the characteristics of each of alcohols;
Fig. 4 is a diagram that shows a relationship between ethanol concentrations in ethanol-water mixed liquids and limit heat fluxes thereof;
Fig. 5 is a diagram that shows a relationship between separation distances and heat transfer coefficients;
Fig. 6 is a diagram that shows a relationship between return-separation distances and heat transfer coefficients;
Fig. 7 is a diagram that shows a relationship between ethanol concentrations in ethanol-water mixed liquids and heat transfer coefficients thereof;
Fig. 8 is a schematic diagram for explaining filmboiling;
Fig. 9 is a diagram that shows relationships between ethanol concentrations in ethanol-water mixed liquids and temperatures of elements; and
Fig. 10 is a schematic perspective diagram that illustrates an ebullient cooling device 100, and which corresponds to the "A"-"A" cross-sectional diagram.

### Explanation on Reference Numerals

1, and 100: Ebullient Cooling Devices;
2, and 20: Accommodating Units;
21: Heat-receiving Passage;
201: First Heat-receiving Passage;
202: Second Heat-receiving Passage;
22, and 23: Supplying Passages;
21a, 201a, 201b, 202a, and 202b: Heat-transferring Wall Portions;
3, and 30: Condensing Units;
31, 301, and 302: Condensing Pipes;
23, 51, and 52: Partition Plates; and
"Z," and "Z1" through "Z4": Heating Elements

### BEST MODE FOR CARRYING OUT THE INVENTION

Next, the present invention will be explained in more detail while giving an embodiment mode.

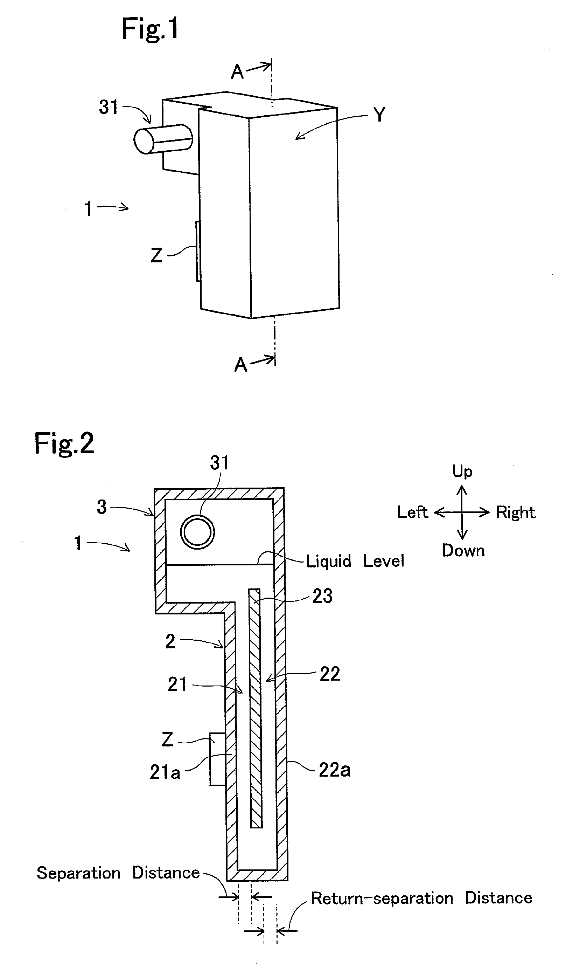

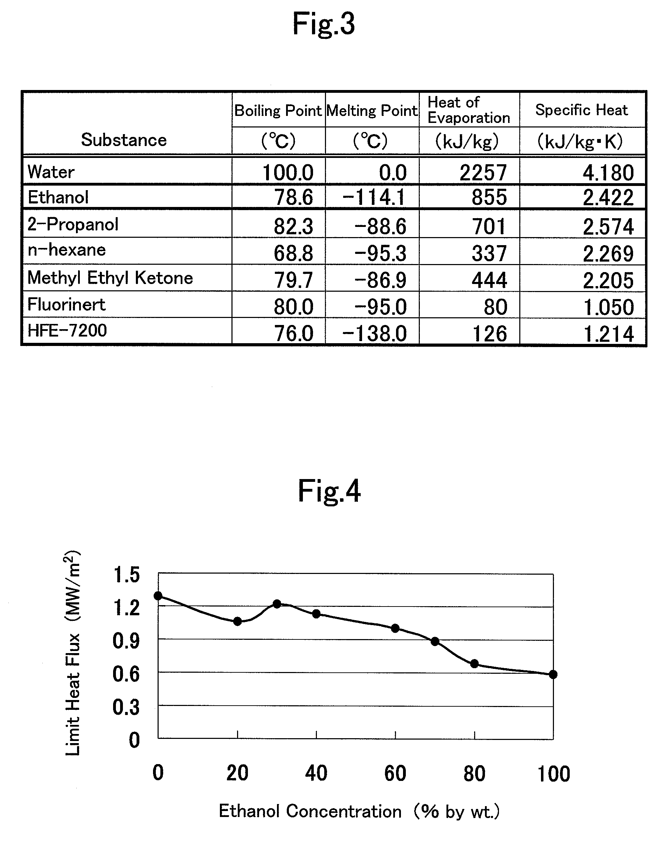

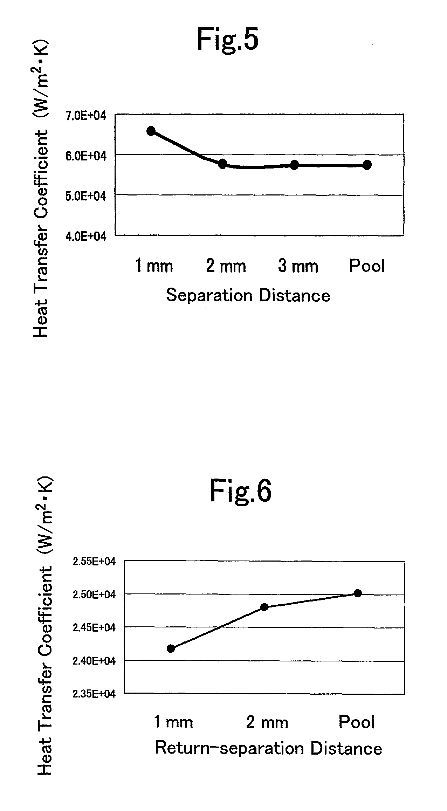

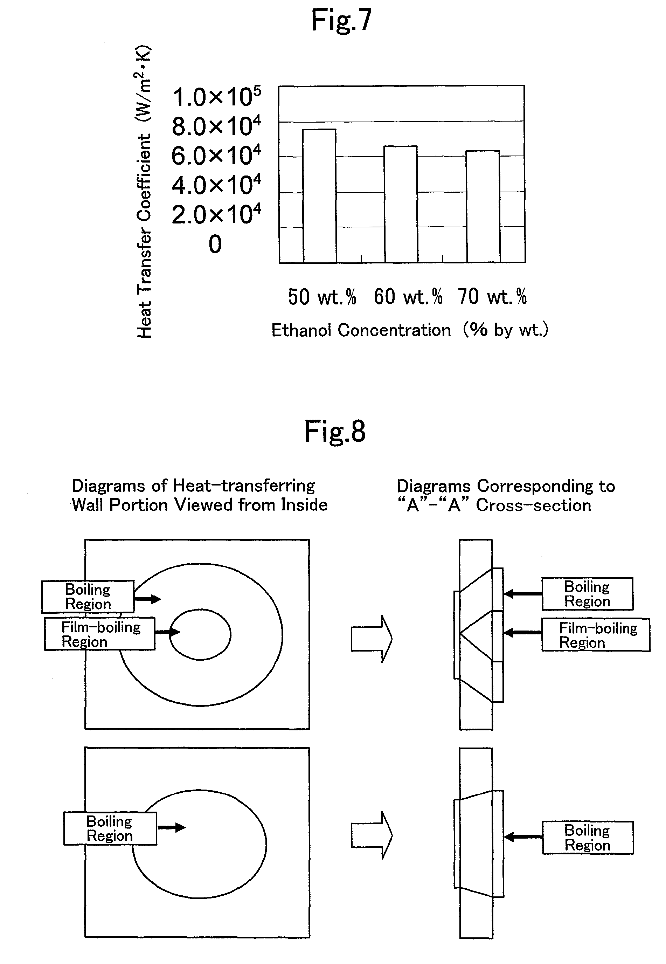

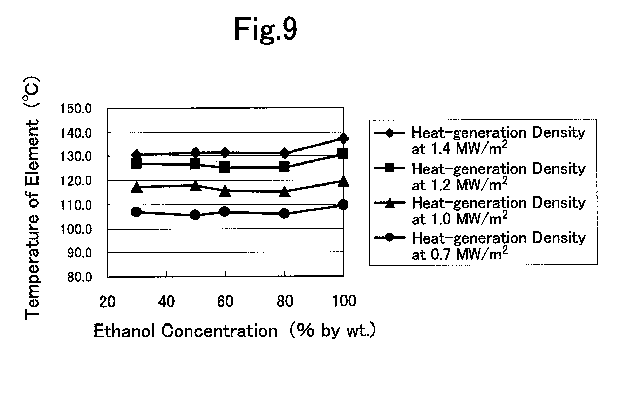

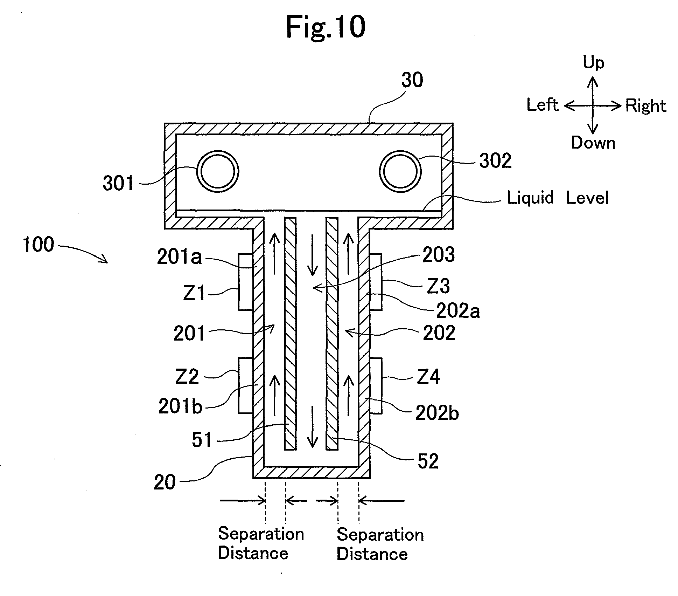

Explanations will be made on an ebullient cooling device according to the present embodiment mode with reference to Fig. 1 through Fig. 10. Fig. 1 is a schematic perspective diagram that illustrates an ebullient cooling device 1. Fig. 2 is a cross-sectional diagram being viewed in the direction of "A"-"A" in Fig. 1. Fig. 3 is a diagram that shows the characteristics of each of alcohols. Fig. 4 is a diagram that shows a relationship between ethanol concentrations in ethanol-water mixed liquids and limit heat fluxes thereof. Fig. 5 is a diagram that shows a relationship between separation distances and heat transfer coefficients. Fig. 6 is a diagram that shows a relationship between return-separation distances and heat transfer coefficients. Fig. 7 is a diagram that shows a relationship between ethanol concentrations in ethanol-water mixed liquids and heat transfer coefficients thereof. Fig. 8 is a schematic diagram for explaining film boiling. Fig. 9 is a diagram that shows relationships between ethanol concentrations in ethanol-water mixed liquids and temperatures of elements. Fig. 10 is a schematic perspective diagram that illustrates an ebullient cooling device 100, and which corresponds to the "A"-"A" cross-sectional diagram. Note that Fig. 4 is cited from "Matorir, A.S., Heat Transfer Soviet Research, 5-1 (1973), pp. 85-89."

As illustrated in Fig. 1 and Fig. 2, an ebullient cooling device 1 comprises a container "Y" whose inner space is divided by a partition plate 5, and is equipped with an accommodating unit 2, and a condensing unit 3.

The accommodating unit 2 is a metallic container whose cross section has a rectangular parallelepiped configuration, and a liquid cooling medium is collected and stored in the interior. The accommodating unit 2 is equipped with a heat-receiving passage 21, a supplying passage 22, and a partition plate 23. Roughly speaking, the heat-receiving passage 21 is a part that is surrounded by side wall faces (or four faces) that include the following: a side wall face including a heat-receiving wall portion 21a of the accommodating unit 2 onto which a heating element "Z" is to be installed; and the partition plate 23 that faces the aforementioned side wall face. The partition plate 23 forms one of the side faces of the heat-receiving passage 21, and one of the side faces of the supplying passage 22, thereby dividing the inner space of the accommodating unit 2 into the heat-receiving passage 21 and the supplying passage 22. The heating element "Z" is a semiconductor element, for instance.

The heat-receiving passage 21 is formed as a rectangular parallelepiped configuration substantially, is opened at the top to lie successively to the condensing unit 3, and is opened at the bottom to lie successively to the supplying unit 2. The heat-transferring wall portion 21, and the partition plate 23 are parallel to each other. In the present embodiment mode, a separation distance between the heat-transferring portion 21a and the partition plate 23 (corresponding to the "facing wall portion" in the present invention) is made to be roughly 1 mm.

The heat-receivingpassage 21 accommodates the liquid cooling medium in the interior. The heat-transferring wall portion 21a of the heat-receiving passage 21 is a part that conveys heat resulting from the heating element "Z" to the liquid cooling medium. The liquid cooling medium inside the heat-receiving passage 21 receives the heat of the heating element "Z" to boil, and then turns into bubbles to rise within the liquid cooling medium. The supplying passage 22 will be described later.

The condensing unit 3 is positioned above the accommodating unit 2, and is opened at the bottom to lie successively to the heat-receiving passage 21, and to the supplying passage 22. In the condensing unit 3, a condensing pipe 31 is disposed. In the condensing pipe 31, coolant water is flowing. The condensing unit 3 cools and then condenses vapors that rise from the heat-receiving passage 21.

The supplying passage 22 parallels the heat-receiving passage 21, and is a part on another one of the sides that is made inside the accommodating unit 2, and which is separated from the heat-receiving passage 21 by the partition plate 5. The supplying passage 22 is opened at the top to lie successively to the condensing unit 3, and is opened at the bottom to lie successively to the heat-receiving passage 21. The liquid cooling medium that has been condensed at the condensing unit 3 turns into liquid droplets to drop down into the supplying passage 22 mainly. The supplying passage 22 receives the liquid cooling medium that drops down from the condensing unit 3, and then supplies the liquid cooling medium to the heat-receiving passage 21 from down below by means of pressure difference. Note that the ebullient cooling device 1 is put in a sealed state completely. The liquid cooling medium is sealed into a container (i.e., the ebullient cooling device 1) that is in a vacuum state.

Explanations are made herein on the cooling medium to be accommodated in the accommodating unit 2. The liquid cooling medium is a mixed liquid of water and ethanol. In the present embodiment mode, this mixed liquid has an ethanol concentration of roughly 50% by mass (or wt. %). Ethanol exhibits a relatively low boiling point, namely, 78.6 °C. Ethanol is effective as a cooling medium for ebullient cooling device, because the boiling temperature is low. Moreover, in the present embodiment mode, the coolant water with roughly 65 °C is being flowed in the condensing pipe 31. Consequently, it is advisable that the boiling point can be higher than 65 °C moderately. In this perspective as well, it is effective to use ethanol for the mixed liquid.

Moreover, ethanol has a heat of evaporation (or latent heat) that is 855 (kJ/kg), and the heat of evaporation is larger than those of the other alcohols. Consequently, ethanol exhibits a larger limit heat flux. That is, using the mixed liquid of water and ethanol can make the resulting limit heat flux (MW/m²) larger than using the other alcohols. Since the limit heat flux and a heat flux causing burnout are proportional to one another, being a larger limit heat flux is more advantageous. Note that water has a larger heat of evaporation than does ethanol.

In addition, as shown in Fig. 3, ethanol exhibits a lower melting point (i.e., -114.1 °C) compared with those of the other alcohols. Consequently, the mixing amount that is necessary for the mixed liquid to exhibit a targeted melting-point temperature (e.g., less than -30 °C herein) can be less than those of the other alcohols. Since water has a larger heat of evaporation than do alcohols, the greater the water component is the larger a limit heat flux of the mixed liquid becomes. Even when ethanol is present in a small amount relatively, it is possible to lower the melting point. As a result, it is possible to make the water component greater and hence make the resulting limit heat flux larger. Thus, in the present embodiment mode, ethanol is an optimum option to be mixed with water.

For example, let us consider a case where HFE-7200 is used for the mixing with water. As shown in Fig. 3, HFE-7200 is effective in lowering the melting point of the resulting mixed liquid, because it exhibits a lower melting point than does ethanol. However, since the heat of evaporation is smaller considerably compared with that of ethanol, it becomes difficult to secure an adequate heat of evaporation after the mixing. That is, it becomes difficult to inhibit the occurrence of burnout.

Moreover, let us consider another case where 2-propanol is used for the mixing with water, for instance. 2-propanol is effective for inhibiting burnout from occurring, because it exhibits a larger heat of evaporation relatively. However, since 2-propanol exhibits a higher melting point than does ethanol, the same melting point as that of a water-ethanol mixed liquid is not obtainable unless 2-propanol is mixed in a greater amount than is ethanol. Eventually, the resulting heat of evaporation has declined, because it is necessary to augment a mixing ratio of 2-propanol with respect to water in order to lower the resultant melting point. In addition, the heat of evaporation of 2-propanol is smaller than that of ethanol. As described above, water-ethanol mixing is optimum in order to let both of the advantages, preventing freezing and inhibiting the occurrence of burnout, be demonstrated.

Explanations are made herein on the ethanol concentration. As illustrated in Fig. 4, it can be seen that the limit heat flux differs when the ethanol concentration differs in the mixed liquid of water and ethanol. As aforementioned, the magnitude of limit heat flux and the magnitude of heat flux at which burnout occurs are in a proportional relationship to one another. As illustrated in Fig. 4, the limit heat flux becomes larger in a case where the ethanol concentration is roughly 75% by mass or less. That is, using the mixed liquid whose ethanol concentration is roughly 75% by mass or less is preferable for the inhibition of burnout.

However, the lower the ethanol concentration becomes, the higher the melting point becomes, and so the more likely it becomes to freeze. In particular, in order to be a liquid cooling medium to be used for ebullient cooling devices to be boarded on vehicle, it has been required in general that the liquid cooling medium be one which does not freeze at roughly -30 °C. Hence, a freezing experiment was carried out for the mixed liquid whose ethanol concentration was 40% by mass. As a result, it was ascertained that the aforementioned mixed liquid did not freeze in a -35 °C atmosphere. That is, when the ethanol concentration is 40% by mass or more, the mixed liquid exhibits a melting point being that temperature or less, and hence does not at all freeze even at -30 °C. It is thus possible to clear the required specification for installation in vehicle. Moreover, as described above, the resulting limit heat flux becomes larger than that of ethanolic single component, because the water component whose limit heat flux is larger is included in the mixed liquid.

Thus, it is preferable that a liquid cooling medium to be used for vehicular ebullient cooling device can be a mixed liquid (e.g., water plus ethanol) whose ethanol concentration is from 40% by mass or more to 75% by mass or less. In accordance with this setting, the freezing can be prevented, and the burnout can be inhibited.

Moreover, it is preferable that the ethanol concentration can be 45% by mass or more in order to furthermore securely prevent the freezing. For example, when the ethanol concentration is 50% by mass approximately, the resulting melting point becomes smaller than -40 °C , and hence it is possible to clear the required specification for cold area (e.g., being non-freezable at -40 °C) as well. That is, by using the mixed liquid whose ethanol concentration is 45-75% by mass, it is possible to more securely prevent the freezing, and to make the limit heat flux larger so as to inhibit the burnout.

Note herein that, in the present embodiment mode, the separation distance between the heat-transferring wall portion 21 and the partition plate 5 is made to be roughly 1 mm. In Non-patent Literature No.1, the following are described: heat transfer is facilitated, compared with pool boiling, when making the aforementioned separation distance (i.e., the gap between the heat-transferring wall portion 21a and the partition plate 23) smaller. For example, in cases where the separation distance is 2 mm, 1 mm and 0.6 mm, respectively, the resulting heat transfer is facilitated remarkably in lower heat-flux range. The larger the heat transfer coefficient is, the more favorable the resultant cooling performance becomes.

In the same construction as that of the present embodiment mode, the aforementioned separation distance was altered to experiment differences between the resulting heat transfer coefficients. In this experiment, the mixed liquid with an ethanol concentration of 60% by mass was used. The heat flux in the heating element was from 1-2 (MW/m²). As illustrated in Fig. 5, the heat transfer coefficient rose when the separation distance was 2 mm or less. However, since a limit bubble diameter is roughly 1.5 mm in the liquid mixture of water and ethanol, it is believed that favorable heat transfer can be carried out maximally up to 3 mm that is equivalent to the double of that value. That is, provided that the separation distance is 3 mm or less, it is advantageous in the prospect of heat transfer. Preferably, the separation distance can be 2 mm or less. A more preferable separation distance can be from 0.5 mm or more to 1.5 mm or less in which 1 mm makes the center.

Moreover, a similar experiment was carried out for the separation distance between the partition plate 23 and the wall portion 22a on the side of the supplying passage 22 (being referred to as a "return-separation distance" hereinafter) as well. As illustrated in Fig. 6, it is understood that the return-separation distance can suitably be in the vicinity of 2 mm. The return-separation distance was made to be 2 mm in the present

### embodiment mode.

Subsequently, in the present embodiment mode, the ethanol concentration in the mixed liquid was changed to carry out an experiment on the resulting heat transfer coefficients while setting the separation distance at 1 mm between the heat-transferring wall portion 21a and the partition plate 23. As illustrated in 7, it is understood the heat transfer coefficient became higher (roughly 7.8 × 10⁴ (W/M²·K)) when the ethanol concentration was 50% by mass. Moreover, even when the ethanol concentration was 60% by mass and 70% by mass, it is understood that the heat transfer coefficients became higher (roughly 6.5 × 10⁴ (W/m²·K) at 60% by mass, and roughly 6.3 × 10⁴ (W/m²·K) at 70% by mass).

As to the limit heat flux, it became larger gradually from 75% by mass toward 30% by mass, as illustrated in Fig. 4. From the viewpoints of the burnout inhibition (e.g., 75% by mass or less), the freeze prevention (e.g., 40% by mass or more), and the aforementioned heat transfer coefficient, it is possible to say that the ethanol concentration that is suitable for mounting on vehicle can roughly be from 45% by mass or more to 75% by mass or less that centers about 50-70% by mass where the heat transfer coefficient is higher. More preferably, it can be from 45% by mass or more to 55% by mass or less in which 50% by mass makes the center at which the heat transfer coefficient is the highest. It is believed that a cause of the heat-transfer-coefficient improvement would be the difference in physical properties between water vapor and ethanol vapor toward boiling in such a narrow gap whose separation distance is 3 mm or less.

In the present embodiment mode, the separation distance was 1 mm, and the ethanol concentration in the mixed liquid was 50% by mass. As aforementioned, in accordance with these settings, it is possible to prevent the liquid cooling medium from freezing, and the burnout can be inhibited from occurring.

Note that, as illustrated in Fig. 8 (the upper diagrams), film boiling occurs in the vicinity of the inner face of the heat-transferring wall portion 21a that corresponds to the central part of the heating element "Z" (namely, the part that becomes the highest temperature). When film boiling occurs, no heat transfer is carried out in a region where it has occurred (namely, a film-boiling region) , because the liquid cooling medium cannot make contact with the heat-transferring wall portion 21a therein. Because of this, the cooling performance has declined. Moreover, the transfer of heat expanded to the surrounding area while avoiding the film-boiling region. That is, the heat-transfer distance has become longer. Thus, the thermal resistance becomes larger with respect to heat that conveys through the heat-transferring wall portion 21a, and hence the heat-transferring performance has also been declined. For example, in a case where the heat-generation density of the heating element "Z" is one that exceeds 1 MW/m², film boiling might possibly arise in an ethanolic single-component liquid cooling medium.

However, it is possible to inhibit the occurrence of film boiling by making use of the aforementioned preferable mixed liquid as a liquid cooling medium. Because film boiling is inhibited, the liquid cooling medium makes contact with the heat-transferring wall portion 21a's inner face, and the expansion of heat is prevented on or during heat transfer, as illustrated in Fig. 8 (the lower diagrams). Because the heat-transfer distance also becomes shorter, the cooling performance and heat-transferring performance upgrade.

Moreover, in the relationship between the heat-generation density of the heating element "Z" and the ethanol concentration, the element's temperature became higher, regardless of the heat-generation density, when the ethanol concentration was 80-100% by mass, as illustrated in Fig. 9. That is, it is understood that being 80% by mass or less in the ethanol concentration can be better. From this result as well, it is understood that an effective ethanol concentration can be 40-75% by mass.

Note that, in the present embodiment mode, the separation distance is set at 1 mm and the ethanol concentration is set at 50% by mass as optimum modes. However, these numerical values are not those from which errors are excluded. Even when deviations arise more or less in the numerical values, the aforementioned advantages can be demonstrated. That is, the numerical values in the present embodiment mode possess breadths more or less, and so certain deviations resulting from errors, and the like, are involved in the present embodiment mode. For example, for the ethanol concentration being 50% by mass, it is allowable that the lower limit can fall within a range of 49-48% by mass, and that the upper limit can fall within a range of 51-52% by mass. Similarly, for the separation distance being 1 mm, too, it is permissible that it can be 0.9-1.1 mm.

Moreover, as a modified mode of the present embodiment mode, it is even allowable that the ebullient cooling device can have a construction shown in Fig. 10. Fig. 10 is a diagram that illustrates an ebullient cooling device 100, and which corresponds to the "A"-"A" cross-sectional diagram. As illustrated in Fig. 10, the ebullient cooling device 100 comprises a condensing unit 30, and an accommodating unit 20 whose interior is divided by two partition plates 51 and 52. The accommodating unit 20 is equipped with a first heat-receiving passage 201, a second heat-receiving passage 202, a supplying passage 203, and the partition plates 51 and 52.

The first heat-receiving passage 201 is formed as a rectangular parallelepiped substantially. Roughly speaking, the first heat-receiving passage 201 is a part that is surrounded by side wall faces that include the following: the partition plate 51 on the left side; and a side wall face including heat-transferring wall portions 201a and 201b onto which heating elements "Z1" and "Z2" are installed. The second heat-receiving passage 202 is formed as a rectangular parallelepiped substantially. Roughly speaking, the second heat-receiving passage 202 is a part that is surrounded by side wall faces that include the following: the partition plate 52 on the right side; and a side wall face including heat-transferring wall portions 202a and 202b onto which heating elements "Z3" and "Z4" are installed.

The heat-receiving passages 201 and 202 are opened at the top to lie successively to the condensing unit 30, and are opened at the bottom to lie successively to the supplying passage 203, respectively. Inside the heat-receiving passages 201 and 202, the aforementioned liquid cooling medium is accommodated. A separation distance between the side wall face, which includes the heat-transferring wall portions 201a and 201b, and the partition plate 51 is made to be 3 mm or less (e.g., roughly 1 mm herein). A separation distance between the side wall face, which includes the heat-transferring wall portions 202a and 202b, and the partition plate 52 is also made to be 3 mm or less (e.g., roughly 1 mm herein).

The supplying passage 203 is formed as a rectangular parallelepiped substantially, and is a part that is interposed by the partition plate 51 and the partition plate 52. The supplying passage 203 is opened at the top to lie successively to the condensing unit 30, and is opened at the bottom to lie successively to the heat-receiving passages 201 and 202. A separation distance between the partition plate 51 and the partition plate 52 is made to be roughly 2 mm.

The condensing unit 30 is positioned above the heat-receiving passages 201 and 202, and above the supplying passage 203. In the condensing unit 30, there are disposed condensing pipes 301 and 302 in which coolant water flows. The liquid cooling medium (i.e., the mixed liquid) according to the present embodiment mode, which is accommodated in the heat-receiving passages 201 and 202, receives heat from the respective heating elements "Z1" through "Z4," and then boils. Vapors having risen are condensed at the condensing unit 30. The condensed liquid cooling medium drops down into the supplying passage 203 mainly. The supplying passage 203 receives the liquid cooling medium that drops down from the condensing unit 30, and then supplies the liquid cooling medium to the heat-receiving passages 201 and 203 from down below by means of pressure difference (see the arrow in Fig. 10). In accordance with this setting, too, the same advantages as those of the present embodiment mode are demonstrated, because the aforementioned mixed liquid is used.

It is even allowable that the ebullient cooling device according to the present embodiment mode can have a construction like the following: the heating element is constituted of a substrate, and a heat-generating element being disposed on the substrate; and not only a hole is formed in one of the side walls of the accommodating unit but also the substrate is put in place so as to block that hole, and thereby the substrate makes contact with the cooling medium directly. In that case, the substrate is considered a part of the accommodating unit, and the substrate corresponds to the heat-transferring wall portion. Moreover, it is also permissible that it can have such a construction that the heating element is put in place within the accommodating unit to be immersed in the cooling medium. Moreover, as for a heat exchanger, it is not limited to such a heat exchanger in which the cooling medium is being held or reserved within a bottomed container, but it is even allowable that it can have such a construction in which the cooling medium is flowing without being held or reserved. In accordance with the present invention, it is possible even for those constructions as described above to demonstrate the same advantages as those mentioned above.

## Claims

1. An ebullient cooling device being **characterized in that**:
it is an ebullient cooling device comprising:
an accommodating unit in which a liquid cooling medium is accommodated, the liquid coolingmedium receiving heat that results from a heating element;
it is an ebullient cooling device to be installed in vehicle;
said liquid cooling medium is a mixed liquid of water and ethanol; and
said mixed liquid has an ethanol concentration of 40% by mass or more.

2. The ebullient cooling device as set forth in claim 1 further comprising a condensing unit that lies successively to said accommodating unit, and which condenses said liquid cooling medium that has been boiled by means of the heat of said heating element; and
said ebullient cooling device makes a sealed system.

3. The ebullient cooling device as set forth in claim 1 or 2, wherein said mixed liquid has an ethanol concentration of from 45% by mass or more to 75% by mass or less.

4. The ebullient cooling device as set forth in either one of claims 1 through 3, wherein said mixed liquid has an ethanol concentration of from 45% by mass or more to 55% by mass or less.
